(19) Europäisches Patentamt
European Patent Office
Office européen des brevets

(11) EP 0 396 103 B1

(12) **EUROPEAN PATENT SPECIFICATION**

(45) Date of publication and mention
of the grant of the patent:
**03.04.1996 Bulletin 1996/14**

(51) Int Cl.⁶: **H03J 7/28**

(21) Application number: **90108272.7**

(22) Date of filing: **30.04.1990**

(54) **Channel selecting apparatus**

Kanalwählendes Gerät

Appareil sélecteur de canaux

(84) Designated Contracting States:
**DE FR GB**

(30) Priority: **01.05.1989 JP 112894/89**

(43) Date of publication of application:
**07.11.1990 Bulletin 1990/45**

(73) Proprietor: **KABUSHIKI KAISHA TOSHIBA**
**Kawasaki-shi, Kanagawa-ken 210, Tokyo (JP)**

(72) Inventor: **Tomita, Shigeru**
**Ojima-machi, Nitta-gun,**
**Gunma-ken 370-04 (JP)**

(74) Representative: **Lehn, Werner, Dipl.-Ing. et al**
**Hoffmann, Eitle & Partner,**
**Patentanwälte,**
**Postfach 81 04 20**
**D-81904 München (DE)**

(56) References cited:
**US-A- 4 375 651**    **US-A- 4 510 623**

• **PATENT ABSTRACTS OF JAPAN, vol. 12, no.**
**246 (E-632), 12th July 1988;**
• **& JP-A-63 036 608 (SONY CORP.) 17-02-1988**

## Description

This invention relates to a channel selecting apparatus to be used for CATV receivers and TV receivers.

US-A-4.510 623 discloses an electronically tunable receiver comprising a tuner controlled by a tuning voltage and controlling means for controlling the tuning voltage of the tuner. A microprocessor receives a user input indicating a desired channel. The microprocessor normally loads a programmable constant in a programmable frequency divider to cause the tuner to be tuned to the desired channel. To lock-out specific television channels from display, the microprocessor is programmed to respond to a user entered lock-out code sequence to store in a non-volatile memory one or more channels to be inhibited for a predetermined period of time. Should the user input indicate one of the inhibited channels, the micro processor does not load the corresponding programmable constant in the programmable frequency divider with the result that the television receiver continues to receive the last valid channel selected. The arrangement is such that indicators for all inhibited channels are stored in the non-volatile memory so that all indicators can be cleared in response to a master key code. The electronically tunable receiver is not described to be used in connection with the CATV system.

Generally, the CATV is multi-channeled to diversify the television service. For example, in the United States of America, a multi-channel CATV system realizing the transmission exceeding 100 channels is operated and a channel selecting system including a tuner so that the receiver may also correspond to it is designed.

As a channel selecting operation system wherein the receiving channel is designated in a CATV receiver or television receiver, there is a system wherein the channel number is continuously sequentially switched. That is to say, the channel number is sequentially made to rise up to a larger number from a smaller number or to fall down reversely to a smaller number from a larger number to select a desired channel. This is called an up/down channel selecting system.

In this up/down channel selecting system, in order to elevate the operatability it is generally set to move to the next channel by skipping over a channel not broadcasting at the time of selecting the channel or a channel in which no receiving is desired. That is to say, it is preset to skip the channel. In a presetting method, the number of the channel desired to be selected is memorized in the address position corresponding to this channel number of a memory (RAM), a region in which the information as to whether this channel is skipped or not is written, that is, a skip flag is set and the skip information of each channel is memorized in the skip flag.

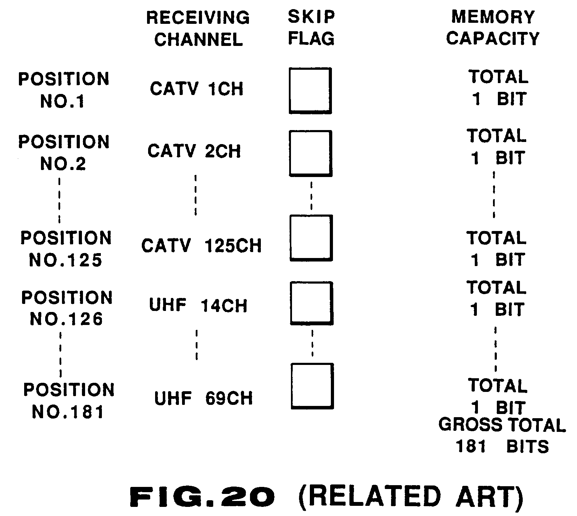

In a receiver wherein the same tuner is used so that both of a CATV and TV may be received, as shown in Fig. 20, for example, a total of 181 CH of 1 to 125 CH (CH is an abbreviatin of the channel here and also hereinafter) of the CATV and 14 to 69 CH of the UHF of the TV are made to correspond to position numbers 1 to 181 and are provided respectively with skip flags. By the way, the case of this example is based on the actual state of the United States of America and 2 to 13 CH of the VHF of the TV and 2 to 13 CH of the CATV are of substantially the same frequency and the same positions.

In the case of the example shown in Fig. 20, one bit is required for each of the skip flags corresponding to 181 CH and a memory capacity of 181 bits is required in order to realize the preset. It is general that such channel selecting system is formed of a microcomputer but, there has been a problem that, as the capacity of the memory (RAM) is limited, if the above mentioned memory capacity (of 181 bits) is to be secured, it will have to be selected whether the function of the microcomputer is reduced or the memory is externallly fitted. That is to say, there has been a problem that the memory (RAM) capacity of the conventional microcomputer is so small that the number of the skip flags can not be taken to be so large.

Summary of the Invention:

The present invention is to eliminate the above mentioned problems and has it as an object to provide channel selecting apparatus wherein the number of skip flags can be made small and the memory (RAM) capacity of the microcomputer can be effectively utilized.

That is to say, the present invention is a channel selecting apparatus comprising a tuner whereby a high frequency signal is mixed with a local oscillation signal controlled by a tuning voltage so as to be converted to an intermediate frequency signal to receive a signal of a desired channel and a controlling means whereby data corresponding to a local oscillation frequency are output in each channel on the basis of a channel-up or channel-down channel selecting operation, a tuning voltage is prepared by using these data and the local oscillation frequency of the above mentioned tuner is controlled, wherein the information as to whether the selection of each channel is to be inhibited or permitted at the time of the channel-up or channel-down channel selection is memorized in the above mentioned controlling means and a common channel selection inhibiting information memorizing means is provided for a plurality of channels not allowed to exist simultaneously.

Brief Description of the Drawings:

Fig. 1 is a block diagram showing an embodiment of the channel selecting apparatus according the present invention.

Fig. 2 is a block diagram showing the formation of an MPU in Fig. 1.

Fig. 3 is an explanatory view for explaining a skip flag and its memory capacity used in the channel selecting apparatus according to the present invention.

Fig. 4 is an explanatory view for explaining a key array of a key operating part used in the apparatus in Fig. 1.

Fig. 5 is a flow chart showing the operation of the MPU when a CATV up-channel selection is made in Fig. 1.

Fig.6 is a block diagram showing a formation in which a means for quickly making a searching operaion at the time of a channel selection is added to the apparatus in Fig. 1.

Figs. 7 to 10 are explanatory views for explaining the operation in Fig. 6.

Fig. 11 is a block diagram showing a formation in which an AFT detecting means is added to the apparatus in Fig. 1.

Fig. 12 is an explanatory view for explaining the operation of the AFT detector in Fig. 11.

Fig. 13 is an explanatory view showing the characteristics of the AFT detector for an actual television signal input in Fig. 11.

Fig. 14 is a block diagram showing an example of an operation circuit within the MPU in Fig. 11.

Figs. 15 and 16 are explanatory views for explaining the operation in Fig. 14.

Fig. 17 is an explanatory view showing the characteristics of the AFT detector in Fig. 11 in the case that there is no broadcast signal in the desired channel.

Figs. 18 and 19 are block diagrams showing other examples of the operation circuit within the MPU in Fig. 11.

Fig. 20 is an explanatory view for explaining a conventional presetting method using skip flags and the memory capacities of the memories then.

Detailed Description of the Preferred Embodiments:

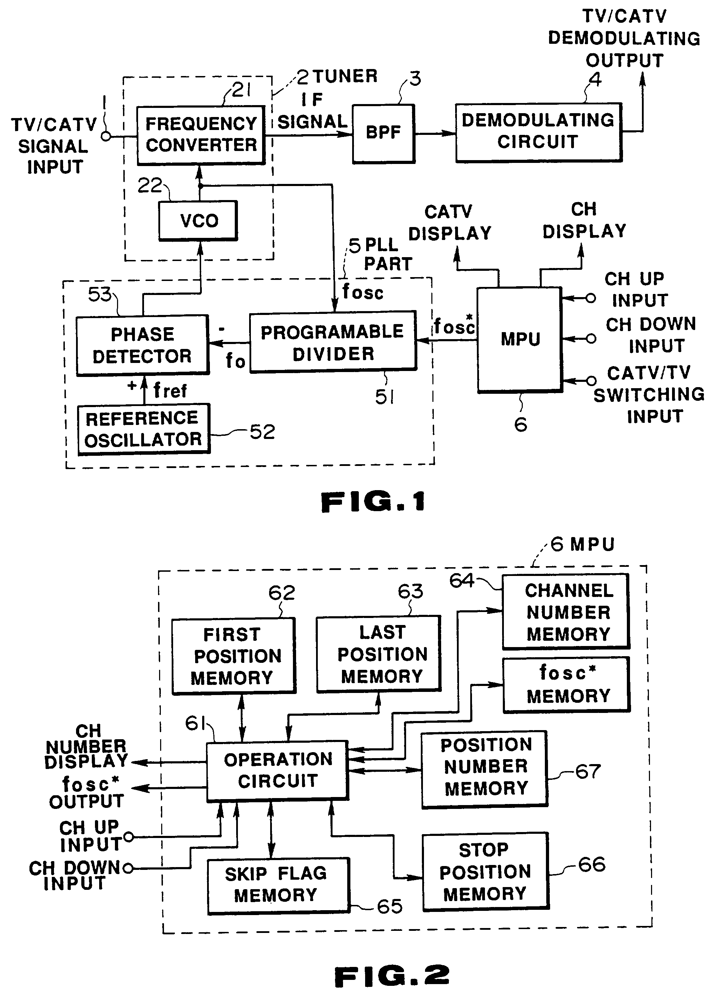

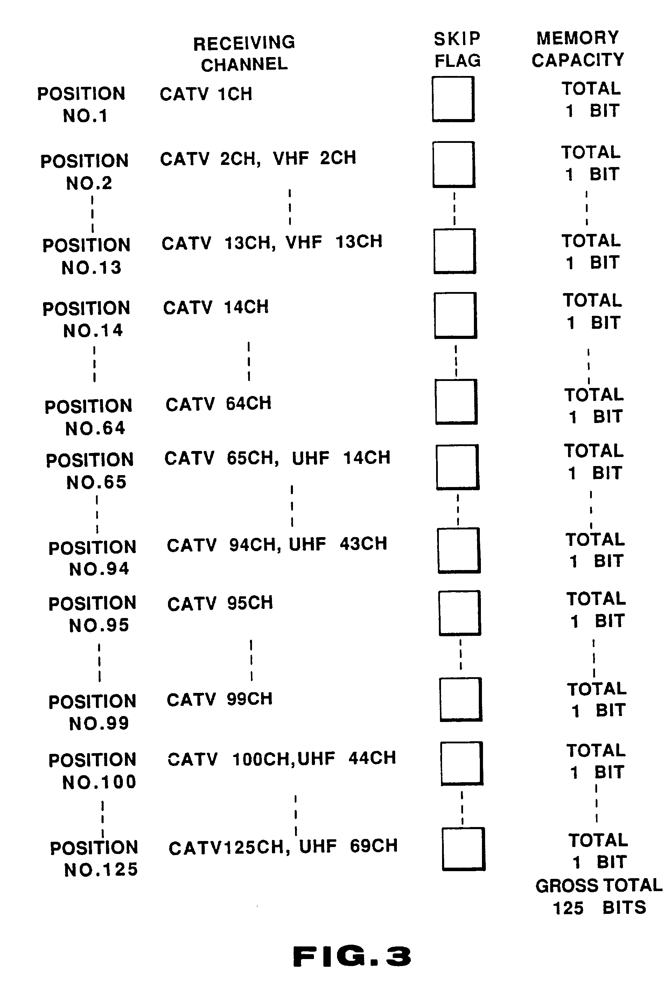

Before explaining an embodiment of the channel selecing apparatus according to the present invention in Figs. 1 and 2, the differences from the conventional example in Fig. 20 shall be explained with reference to Fig. 3.

Fig. 3 is an explanatory view for explaining a skip flag set in the channel selecting apparatus according to the present invention and its memory capacity.

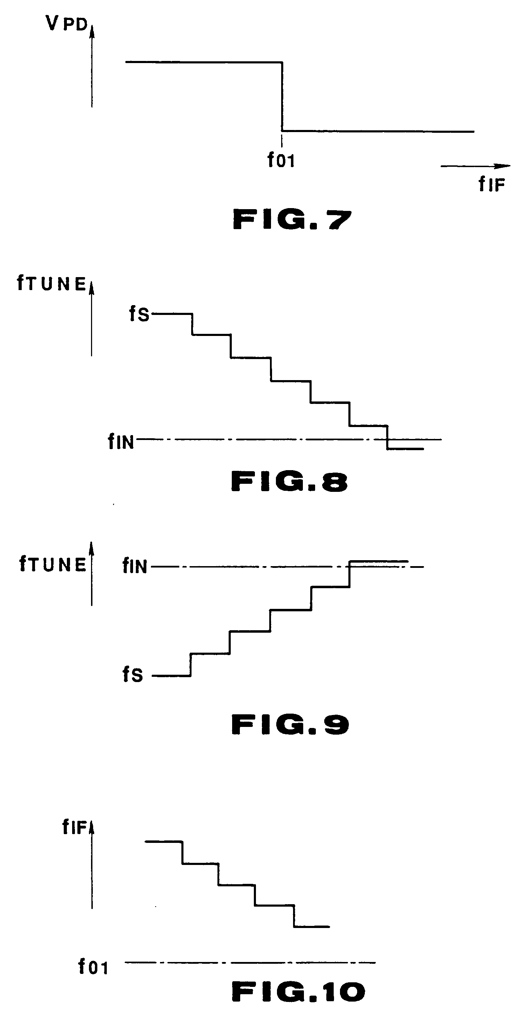

In the embodiment shown in Fig. 3, the skip flags are made common, because, for example, in the United States of America (which shall be mentioned merely as US hereinafter), CATV 2 to 13CH and UHF 2 to 13CH of TV are of the same frequency on the same channel number. Also, on CATV 65 to 94CH, UHF 14 to 43CH of TV and CATV 100 to 125, UHF 44 to 69CH of TV in US, as in, for example, CATV 125CH (of a video carrier frequency of 799.25 $MH_z$) and UHF 69CH ( of a video carrier frequency of 801.25 $MH_z$), the respective channel center frequencies are separated from each other only by 2 $MH_z$, the signals will be mixed if broadcast simultaneously (that is to say, in the M-NTSC system adopted in US, the sole frequency band of one channel is of 6 $MH_z$, whereas the frequency distance between the above mentioned two channels is only 2 $MH_z$) and therefore the skip flags are made common. If the skip flags are thus made common between 1 to 125CH of CATV and CH of VHF and UHF of TV, a memory capacity for 56 bits will be able to be saved as compared with the conventional example in Fig. 6.

That is to say, in this embodiment, in case the receiving channels are set as fixed to 1 to 1 in response to the position numbers and it is judged by using skip flags whether a skip is made or not, in setting the position numbers and receiving channels as fixed to correspond to each other in the step of producing the receiver, CATV 2 to 13CH and VHF 2 to 13CH of TV will be made to correspond to the position numbers 2 to 13 and CATV 65 to 94CH, 100 to 125CH and UHF 14 to 69CH of TV will be made to correspond to the position numbers 65 to 94 and 100 to 125. Therefore, the position numbers may be 1 to 125 corresponding to which skip flags of 125 bits may be provided.

By the way, in another later described embodiment channel selecting apparatus provided with an AFT (automatic fine tuning) detector, the above described difference of a frequency of 2 $MH_z$ can be absorbed and the channel selecting data can be made common in these positions.

From the above, the skip flags can be made common in VHF 2 to 13CH and UHF 14 to 69CH of TV and in CATV 2 to 13 and CATV 65 to 94 and 100 to 125CH.

Fig. 1 is a block diagram showing an embodiment of the channel selecting apparatus according to the present invention. The embodiment in Fig. 1 shows a channel selecting apparatus of a frequency synthesizer system. By the way, in the receiver in which this channel selecting apparatus is used, both CATV and TV signals can be received by using the same tuner.

In Fig. 1, a TV or CATV high frequency signal (which shall be mentioned as an RF signal hereinafter) is input from an antenna or the like not illustrated. This RF signal is fed to a tuner 2 comprising a frequency converter 21 and a voltage controlled oscillator (which shall be mentioned as a VCO hereinafter) 22. The frequency converter 21 converts the input RF signal to an intermediate frequency signal (which shall be mentioned as an IF signal hereinafter) by a local oscillation frequency from the VCO 22 which generates a local oscillation frequency fOSC corresponding to a tuning voltage fed from a PLL part 5. The above mentioned IF signal is fed to a demodulating circuit 4 through a band pass filter (which shall be mentioned as a BPF hereinafter) 3. A TV or CATV demodulating output is obtained from the demodulating circuit 4. On the other hand, a central operation processing apparatus (which shall be mentioned as an MPU hereinafter) 6 generates data fOSC* (digital data delivered by the MPU 6 and represented by a local oscillation frequency expression) corresponding to the local oscillation frequency for each channel on the basis of the up or down input of the channel (that is, the position) and the CATV/TV switching input from a key input means not illustrated and feeds them to the PLL part 5. The MPU 6 will judge whether a skip is to be made or not for each channel with reference to an internal skip flag memory (See Fig. 2) at the up and down time of the channel. Also, the MPU 6 has a function of displaying the channel number and displaying being of the CATV at the up and down time of the channel. The above mentioned PLL part 5 comprises a programable divider 51, a reference oscillator 52 and a phase detector 53. The programable divider 51 is a variable frequency divider dividing the local oscillation frequency fOSC from the VCO 22 by the control signal $fOSC^*$ from the MPU 6. The reference oscillator 52 is formed of a crystal oscillator and generates a reference oscillation frequency f ref. The phase detector 53 compares the phases of the reference oscillation output f ref and the frequency dividing output fo of the programable divider 51 and operates so that, when the phase of fo advances more than f ref, the output will lower. This output is a voltage output and is fed to the VCO 22 which is so formed that, when the input voltage increases, the oscillation frequency will increase. Therefore, as a result, the loop of the VCO 22, programable divider 51, reference oscillator 52 and phase detector 53 will become a PLL (phase synchronizing loop). By this PLL action, fOSC operates to be equal to $fOSC^*$. Therefore, if $fOSC^*$ is delivered from the MPU 6, the local oscillation frequency fOSC of the VCO 22 will be able to be set at any desired value.

Fig. 2 is an internal block diagram of the MPU in Fig. 1. This diagram is explained on the case that the CATV/TV switching input is a CATV input.

As shwon in Fig. 2, the channel up or channel down input is fed to an operation circuit 61 to which are connected a first position memory 62 memorizing 1 position (that is, 1CH) which is the first position of the CATV at the CATV receiving time and a last position memory 63 memorizing 125 position (that is, 125CH) which is the last position of the CATV. These memories 62 and 63 define respectively the upper limit and lower limit of the number of channels at the up/down channel selecting time.

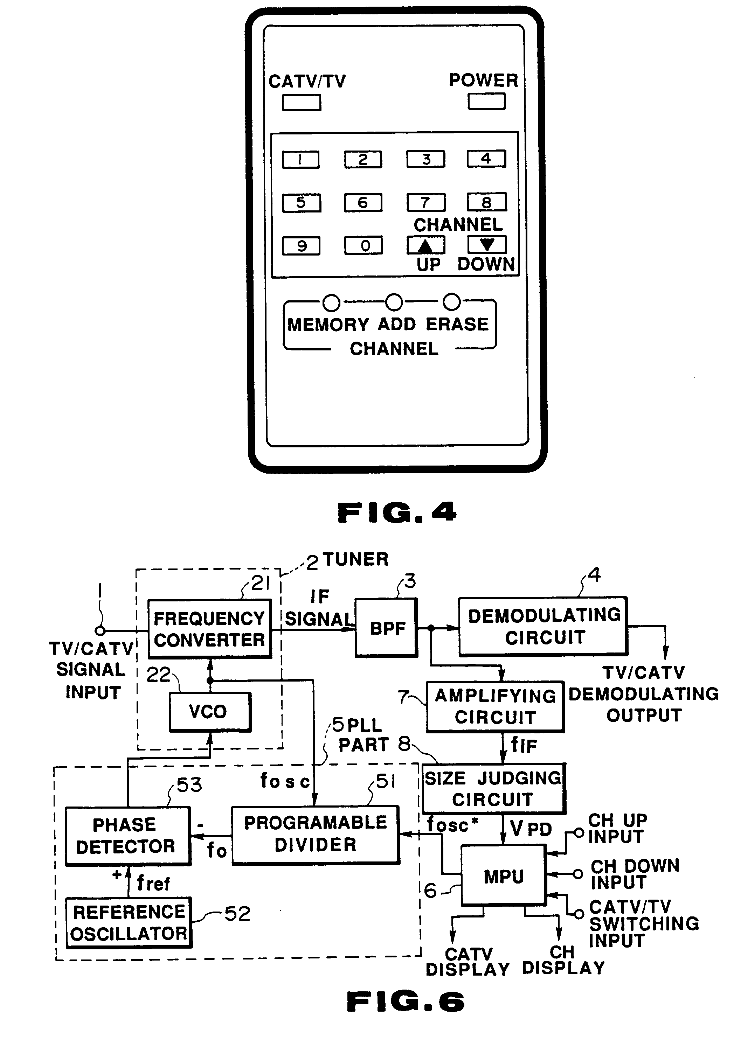

Also, to the operation circuit 61 are connected a channel number memory 64 memorizing channel number data corresponding to the position numbers 1 to 125 of the CATV, a skip flag memory 65 memorizing the information as to whether a skip is to be made or not at the up/down channel selecting time on the respective channels of the CATV and a stop position memory 66 to be used to judge (in the step S4 in Fig. 4) whether the operation is to be pulled out of skip flag reference loop (closed loop of the steps S2 to S5 in Fig. 4) or not when the information to be skipped is memorized in the skip flag memory 65 corresponding to all the positions. In the stop position memory 66, the position number, for example, up by 1 from the present position number (in the step S1 in Fig. 4) is to be memorized at the up/down channel selection starting time point. When the stop position is thus provided, even in case the skip flag 1 stands in all the positions, the reference loop of the above mentioned skip flag will end by one round (that is, in the stop position) and the operation will be able to be pulled out of the reference loop of the skip flags.

Further, to the operation circuit 61 are connected a position number memory 67 memorizing position numbers and an $fOSC^*$ memory memorizing data of $fOSC^*$ corresponding to the channel numbers.

In the above mentioned circuit, in the operation circuit 61, when a channel-up or channel-down input is received, a channel to be selected without skipping will be judged with reference to the skip flag memory 65, the judged selected channel will be memorized in the position number memory 67, data corresponding to this channel will be read out of the channel number memory 64, data $fOSC^*$ corresponding to the local oscillation frequency corresponding to the channel number will be prepared with reference to the $fOSC^*$ memory and will be output to the PLL part 5 and the channel number display data will be output.

Fig. 4 shows an example of a key operating part (remote controlled hand unit) to be used to feed a CH-up input, CH-down input and CATV/TV switching input to the MPU 6. This key operating part is provided with not only a power source key (POWER) switching on/off the power source of the receiver, CATV/TV key switching the CATV/TV, up-channel selecting key (CHANNEL UP) for the CH-up channel selection and down-channel selecting key (CHANNEL DOWN) for the CH-down channel selection but also ten keys 0 to 9 to be used for the direct channel selection or the like by inputting the channel number into the key and further presetting keys (MEMORY, ADD, ERASE) for memorizing in the skip flag memory 65 the information as to whether skipped or not at the time of up/down-selecting the respective channels of the CATV (or TV). Among them, the MEMORY key is an automatically preset auto-key so that, when it is pushed, the respective channels of the CATV (or TV) will be automatically sequentially switched, or so-called searched, the information of selecting the channel in which the signal is present will be memorized (that is to say, the skip-off information will be memorized) and the information of skipping the channel having no signal will be memorized (that is to say, the skip-on information will be memorized). The ADD and ERASE keys are manual keys for the user to manually memorize in the skip flag memory 65 whether the respective channels of the CATV (or TV) are to be skipped or not. For example, at the time of up/down selecting the channel in receiving the CATV, in case it is desired to skip (that is, to be on) only CATV 94CH, when 9 and 4 are pushed with the ten keys and then the ERASE key is pushed, the information to be skipped (on-information) will be able to be memorized in the skip flag memory 65. On the other CH, when the respective channel numbers are pushed with the ten keys and then the ADD key is pushed, the information not to be skipped (that is, off-information) will be able to be memorized in the skip flag memory 65. In the position number 94 CATV 94CH and UHF 43CH have a skip flag in common and therefore, in case the skip flag is on as described above and then CATV 94CH is switched to the TV reception, the skip flag will be on even on UHF 43CH. By the way, also at the time of the TV reception, by the same operation, the information as to whether the respective channels of the VHF and UHF are to be automatically or manually skipped or not will be able to be memorized.

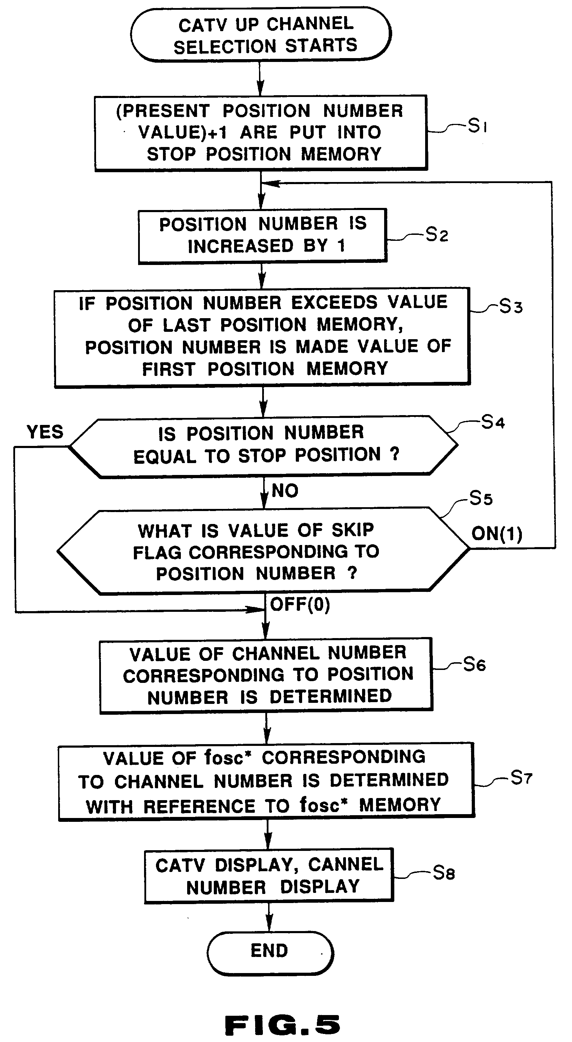

Fig. 5 is a flow chart showing the operation of the MPU when channels are up-selected in the CATV. In the CATV receiving state, when the up-channel selecting key is pushed, as shown in the steps 52 and 53, the position number will be increased by 1 whenever the key is pushed. At this time, in case the number increases by one from the last position, an operation of making the position number the first position will be made. In Fig. 2, when there is a channel-up input, this operation will be made in the operation circuit 61 by referring to the first position memory 62 and last position memory 63. As described above, the step S4 is a step wherein, when the skip flag 1 stands in all the positions, it will be judged whether the skip flag will be pulled out of the reference loop or not. As shown in the step S5, in the process in which the position number is up, the value of the skip flag corresponding to the value of the position number memory 67 is judged. If the skip flag is on (that is, 1), the program will return to the step S2 and the position number will be automatically skipped to the next number. In the step S5, if the skip flag is off (that is, 0), as shown in the steps S6, S7 and S8 the value of the data fOSC* corresponding to the local oscillation frequency corresponding to the position number then will be determined and output and the respective data of the CATV display and channel number display will be output. The operations of the steps S5, S6 and S7 are as explained in Fig. 2.

By the way, the above mentioned embodiment has been explained on the channel selecting apparatus of the PLL frequency synthesizer system but the present invention can be applied to a channel selecting apparatus of a voltage synthesizer system.

As described above, according to the present invention, in the case of skipping the channel not required at the time of the up/down channel selection, a skip flag will be used in common and therefore the number of skip flags can be small. Therefore, the memory (RAM) capacity of the channel selecting microcomputer can be effectively utilized.

Now, in such apparatus as is shown in Fig. 1, in the case of receiving signals (for example, of the above described 125CH of the CATV and 69CH of the UHF) slightly different in the frequency in the same position, the circuit shown in Fig. 6 will be used.

In Fig. 6, an IFAGC amplifying circuit 7 and size judging circuit 8 are provided between the BPF 3 and MPU 6 in Fig. 6. The size judging circuit is a so-called AFT circuit. The frequency dividing ratio of the programable divider 51 is set by the data fOSC* from the MPU 6 in which, when the channel to be selected is designated by the user, the frequency dividing ratio will be renewed sequentially at a predetermined period from a frequency dividing ratio so that the frequency (tuned frequency fTUNE) of the local oscillation signal may be sequentially switched within a fixed range (tuned frequency range) from a tuned frequency (which shall be mentioned as a search starting frequency hereinafter) and may be continuously searched.

Here, the renewal of the frequency dividing ratio of the above mentioned programable divider 51 is controlled according to the size relation between the input signal frequency fIN and search starting tuning frequency fS. That is to say, the IF signal output from the BPF 3 is amplified and controlled to be of a fixed amplitude by the IFAGC amplifying circuit 7. This amplified controlled output is fed to the size judging circuit 8. The frequency fIF of the IF signal fed to this size judging circuit 8 will be different from the inherent intermediate frequency f01 in case the input signal frequency fIN is different from the prescribed frequency. The size judging circuit 8 judges the sizes of this inherent intermediate frequency f01 and the actual intermediate frequency fIF at the time of starting the search to judge the size relation between the input signal frequency fIN and search starting tuned frequency fS. In this case, as shown in Fig. 7, in case the actual intermediate frequency fIN at the time of starting the search, that is, the search starting tuned frequency fS is larger than the input signal frequency fIN, the size judging circuit 8 will output a high level judging signal VDP. On the other hand, in the case reverse to this, a low level judging signal VDP will be output.

At the search starting time point, in case the judging signal VPD is on a high level, the search starting tuned frequency fS will be larger than the input signal frequency fIN and therefore, as shown in Fig. 8, the above mentioned MPU 6 wil renew the frequency dividing ratio of the programable divider 51 in the direction of lowering the tuned frequency fTUNE. On the contrary, in case the judging signal VPD is on a low level, the search starting tuned frequency fS will be smaller than the input signal frequency fIN and therefore, as shown in Fig. 9, the frequency dividing ratio of the programable divider 51 will be renewed in the direction of elevating the tuned frequency fTUNE.

When the renewal of the tuned frequency fTUNE is thus controlled by a negative feedback in response to the size relation between the search starting tuned frequency fS and input signal frequency fIN, as shown in Fig. 10, the actual intermediate frequency fIF will be controlled to be always directed to the inherent intermediate frequency f01 from the search starting time and therefore the searching time of the respective channels may be short. By the way, Fig. 10 shows the case that the search starting tuned frequency fS is larger than the input signal frequency fIN.

By the way, the channel selecting apparatus provided with such AFT circuit as in this embodiment can be applied also to the case that the input signal frequency fIN is offset from the prescribed frequency, for example, as in the HRC (Harmonic Related Carriers) and IRC (Incremental Related Carriers) of the CATV in US.

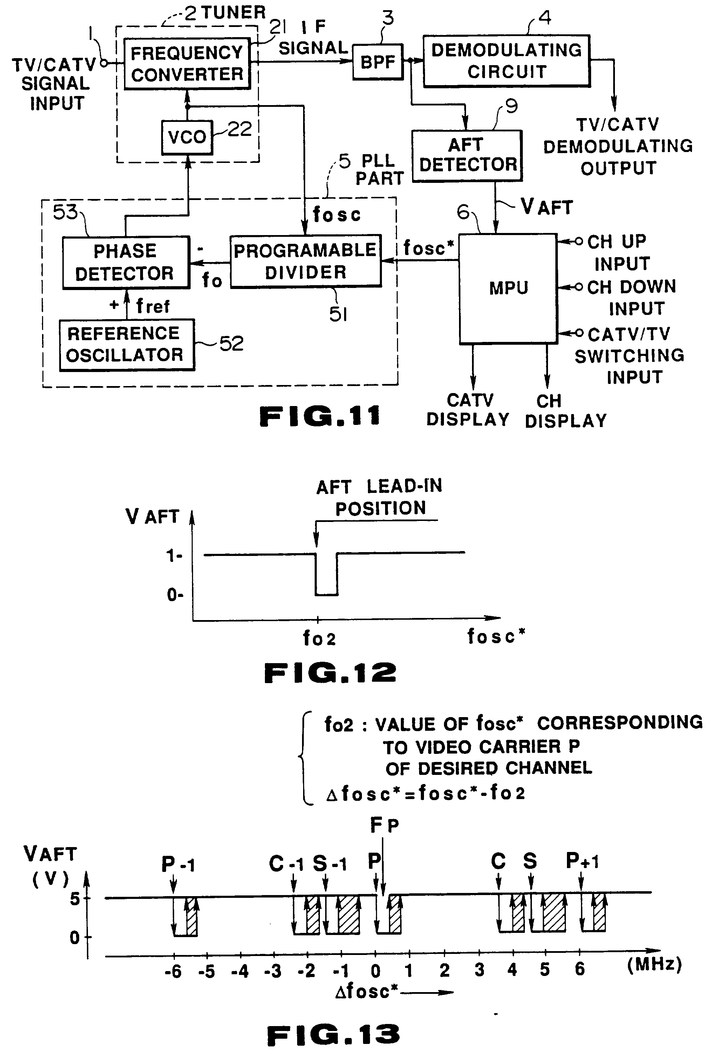

Also, the apparatus shown in Fig. 11 is considered as another example of an apparatus wherein, in the apparatus shown in Fig. 1, in the case of selecting an object channel by the up/down channel selection, even if the input signal frequency of the channel is different from the normal frequency, it will be automatically searched and the skip information will be able to be memorized in the skip flag memory.

In Fig. 11, an AFT detector 9 is provided between the BPF 3 and MPU 6 in Fig. 1. In the AFT detector 9, the frequency variation of the IF signal from the BPF 3 is taken out as a direct current voltage variation and whether the IF frequency is higher or lower than a predetermined value is transmitted to the MPU 6. That is to say, the AFT detector 9 outputs an AFT voltage VAFT and the MPU 6 controls fOSC* (local oscillation frequency expressing data delivered by the MPU) and searches a frequency $f0_2$ in which the VAFT will vary to be on a logical level "0" (0V) from a logical level "1" (5V) when fOSC* is elevated. The relation of VAFT with fOSC* is shown in Fig. 12.

Now, in the searching process in such AFT operation, the AFT will not be led into an objective video carrier P but will be led into a sound carrier S-1 of a lower adjacent channel or into a color sub-carrier C to make a mis-operation. Fig. 13 shows detection characteristics of an AFT detector 9 for an actual television signal. Fig. 13 shows variations of VAFT against the variations of fOSC* P, C and S represent lead-in positions of the AFT repectively by the video carrier, color sub-carrier and sound carrier of the desired channel. S-1 and C-1 represent lead-in positions respectively by the sound carrier and color sub-carrier of the lower adjacent channel. P+1 represents a lead-in position by the video carrier of the upper adjacent channel. Here, if the value of fOSC* corresponding to the video carrier P is f02, $\Delta$ fOSC* = fOSC* - f02. In the drawing, the downward directed and upward directed arrows represent respectively the directions of the variation of VAFT when fOSC* is increased. Within the region (hatched) enclosed by the upward directed arrows on the right side of each carrier position, the VAFT varies upward. That is to say, it is shown that the rising position fluctuates substantially within this hatched range. The downward variation is in only the position in which each carrier is present. The AFT is led into this position.

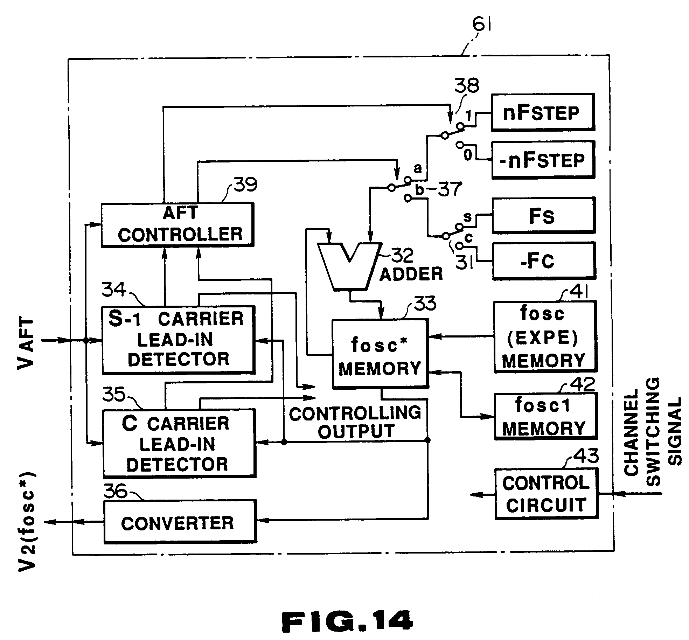

In order to avoid leading into the sound carrier S-1 of the lower adjacent channel or into the color sub-carrier C, the operation circuit 61 (See Fig. 2) within the MPU 6 is formed as shown in Fig. 14 so that the normal reception may be possible. That is to say, in the process of searching the frequency f02 corresponding to the video carrier P, it is detected whether the AFT is led into the objective video carrier P, into the sound carrier S-1 of the lower adjacent channel or into the color sub-carrier C and, in case it is led into the carrier S-1 or carrier C, the video carrier P will be searched again.

In Fig. 14, Fs and -Fc represent means whereby in order to search the carrier P again at the time of detecting respectively the carrier S-1 and carrier C, data of a fixed frequency to be increased or decreased from the value of fOSC* then are generated so that, at the time of detecting the carrier S-1 or carrier C, the FS or -FC may be switched by a switching circuit 31 and the fixed frequency FS or -FC may be fed to an adder 32 at one input end. The value fOSC1 of fOSC* set at the fOSC* memory 33 then is fed to the adder 32 at the other input end.

Here, for example, in the case of an M-NTSC system television signal, the value of FS may be made about 1.5 $MH_z$ + 250 $KH_z$ = 1.75 $MH_z$. The above mentioned 1.5 $MH_z$ is a frequency difference between the video carrier P and the sound carrier S-1 of the lower adjacent channel and is defined to be 1.5 $MH_z$ = {(Channel sole band width of 6.0 $MH_z$) - (Sound intermediate frequency of 4.5 $MH_z$)}. The above mentioned 250 $KH_z$ is a value taking into consideration the above described fluctuation of 125 $KH_z$ of the frequency difference between the channels and the fluctuation of the AFT circuit. The value of FC may be about 3.31 $MH_z$ in the M-NTSC system. Here, 3.31 $MH_z$ (Color sub-carrier frequency of 3.579545 $MH_z$) - 250 $KH_z$.

On the basis of an input channel switching signal, a controlling circuit 43 loads an fOSC* memory 33 from an fOSC (EXPE) memory 41 with fixed frequency data corresponding to a desired channel. The frequency data fOSC* are converted to a voltage value V2 (fOSC*) by a converter 36 to switch the channel. An AFT detector 4 outputs an AFT voltage VAFT corresponding to V2 (fOSC*). An AFT controller 39 operates an AFT loop to search f02. When the AFT is led in, the AFT controller 39 will switch the switching circuit 37 to the b side so that an S-1 carrier lead-in detector 34 and carrier lead-in detector 35 may function. Whether the AFT is detected by the S-1 carrier lead-in detector 34 or by the C carrier lead-in detector 35 depends on whether the value of fOSC* then is on the sound carrier S-1 side of the lower adjacent channel of each channel or on the color sub-carrier C side of each channel.

The S-1 carrier lead-in detector 34 switches the switching circuit 31 to a data generating means FS with its controlling output, stores the value of the fOSC* memory 33 then once in an fOSC1 memory 42 and then increases the value of the fOSC* memory 33 by the predetermined frequency FS. Then, the AFT is measured and, when the VAFT is "0", the carrier P will have been detected and therefore the AFT will be judged to have been led into the carrier S-1 at fOSC. In this case, if the carrier is searched again from the value of the fOSC* memory 33 then, that is, fOSC1 + FS, the AFT will be able to be led into the P carrier. That is to say, the switching circuit 37 is switched to the a side to make a search with F STEP data. The operation of the switching circuit 38 switching the data memories nF STEP and -nF STEP is the same as in the switching circuit 25 of the prior art example (Fig. 10). If VAFT "0" is not detected in fOSC1 + FS, fOSC1 will be judged to be a carrier P and the value of the fOSC1 memory 32 will be returned to the fOSC* memory 33.

The C carrier lead-in detector 35 switches the switching circuit 31 to the data generating means -FC with its controlling output, transfers the value of the fOSC* memory 33 then to fOSC1 decreases the value of fOSC* by the predetermined frequency FC. Then the AFT is measured and, when the VAFT is "0", the carrier P will have been detected and therefore the AFT will be judged to have been led into the carrier C at the value fOSC1 of fOSC*. The same as in the case of S-1, if the switching circuit 37 is switched to the a side and the carrier P is searched by the F STEP unit from the carrier fOSC1-FC, the AFT will be able to be led into the carrier P. If VAFT "0" is not detected in fOSC1-FC, fOSC1 will be considered to have been the carrier P and fOSC* will be returned to fOSC1.

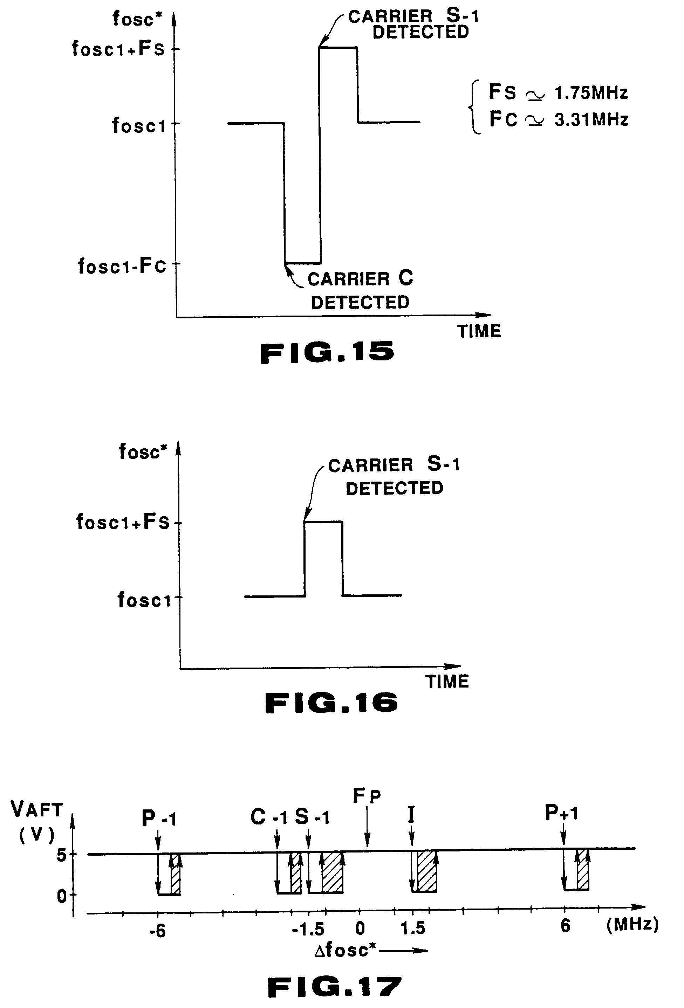

Fig. 15 is to explain an example of the operation of the circuit in Fig. 14. Time is taken on the abscissa and fOSC* is taken on the ordinate. At first, the value of fOSC* is made fOSC1-FC to detect a carrier C. Then, the value of fOSC* is made fOSC1 + FS to detect a carrier S-1. In this case, as the AFT is not led into the carriers C and S-1, the value of fOSC* is returned to fOSC1.

Fig. 16 is to explain another example of the operation of the circuit in Fig. 14 and shows the case of only detecting the carrier S-1. The value of fOSC* is made fOSC1 + FS to detect the carrier S-1. As the AFT has been correctly led into the carrier P by fOSC1, the value of fOSC* is returned to fOSC1.

Now, it shall be explained with reference to Fig. 13 that the above mentioned means is effective.

(1) In case fOSC1 is led into P (that is, when fOSC1 is a frequency f02 corresponding to the carrier P), the carrier C will be detected with $\triangle$ fOSC* = - FC $\simeq$ - 3.31 MH$_z$, therefore VAFT = 5V (that is, logical "1") and no lead-in will be detected. As the carrier S-1 is detected with $\triangle$ fOSC* = - FC $\simeq$ 1.75 MH$_z$, also, at this time, VAFT = 5V and no lead-in will be detected. Therefore, the MPU will return fOSC* to fOSC1 (that is, f02) and it will be normally tuned with the carrier P.

(2) In case it is led into the carrier S-1, the carrier C will be detected with $\triangle$ fOSC* = - 1.5 MH$_z$ - 3.31 MH$_z$ = - 4.81 MH$_z$. Though this frequency is not illustrated, the characteristics in Fig. 13 will be periodically repeated at intervals of 6 MH$_z$ between channels. Therefore, for example, where $\triangle$ fOSC* = 6 MHz - 4.81 MHz = 1.19 MHz, VAFT is 5V and no lead-in is detected. In the carrier S-1 detection, with $\triangle$ fOSC* = - 1,5 MHz + 1.75 MHz = 0.25 MHz, VAFT = 0V and it is judged to have been led into the carrier S-1. Therefore, as the search is resumed from 0.25 MHZ, it can be correctly led into the carrier P.

(3) In case it is led into the carrier C, if the carrier C is detected, $\triangle$ fOSC $\simeq$ 3.58 MHz - 3.31 MHz = 0.27 MHz, therefore VAFT = 0V and it will be judged to have been led into the carrier C. As the search is resumed from 0.27 MHz, it can be correctly tuned with the carrier P. In this case, if the carrier S-1 is detected first, $\triangle$ fOSC* = 3,58 MHz + 1.75 MHz = 5.33 MHz and VAFT will not be determined to be 0V or 5V. Therefore, this is not desirable.

As described above, according to the formation in Fig. 11, as means of discriminating the video carrier P and the sound carrier S-1 of the lower adjacent channel and discriminating the video carrier P and the color sub-carrier C, the frequency differences between S-1 and P and between P and C are utilized and therefore the video carrier P can be discriminated without resorting to a CATV transmitting system (that is, without resorting to the absolute frequency of the video carrier P).

As described above, according to the formation in Fig. 11 and the operation circuit formation in Fig. 14, an automatic channel selection by detecting signals is made possible without causing a mis-operation of selecting channels by leading the AFT into the sound carrier of the lower adjacent channel or the color sub-carrier of the desired channel.

Now, in the frequency searching process by the AFT operation in the apparatus in Fig. 11, in case there is a broadcast signal (that is, there is a video carrier P) in the desired channel, the detecting characteristics of the AFT detector 9 will be as shown in Fig. 13 but, in case there is no broadcast signal in the desired channel, the characteristics of the AFT detector will be as shown in Fig. 17. It is shown that, in this case, when $\triangle$ fOSC* is 1.5 MHz, the AFT will be led into spurious I. In case there is no boradcast signal in the desired channel but there are signals in the upper and lower adjacent channels, when the video carrier P+1 of the upper adjacent channel, the video carrier P-1 of the lower adjacent channel and the sound carrier S-1 of the lower adjacent channel modulate with one another in the frequency converter, this spurious I will be generated. By the way, in Fig. 13, no spurious I appears, because, as there is a signal in the desired channel, the RF amplifier in the front step of the frequency converter is not in the maximum sensitivity state by the AGC operation.

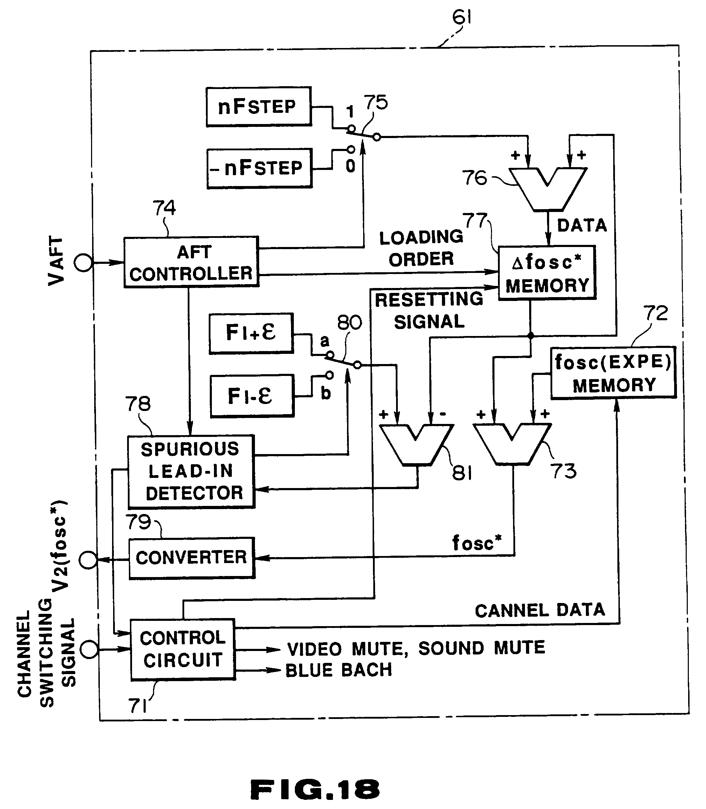

Thus, in case there is no broadcast signal in the desired channel, when the AFT is led into the spurious I, a mixed signal picture will be displayed. Therefore, in order to avoid it, when the operation circuit 61 (See Fig. 2) within the MPU 6 is formed as shown in Fig. 18, a normal signal reception will be possible. That is to say, in the process of searching the frequency f02 corresponding to the video carrier P, when $\triangle$ fOSC* is 1.5 MHz, if the AFT is led into the spurious I (that is to say, if the AFT voltage VAFT becomes "0") or, when $\triangle$ fOSC* is near 0.2 MHz, if the AFT is not led in (that is to say, if the AFT voltage VAFT is not "0"), no broadcast signal will be judged to be in the desired channel. When this non-signal judgment is used, at the time of the up/down channel selection, that channel will not be selected but the next channel will be able to be selected and, at the time of a direct channel selection, the picture will be made blue (or will not be colored) and the sound will be able to be muted.

In Fig. 18, on the basis of the input channel switching signal, a controlling circuit 71 feeds fixed frequency data fOSC (EXPE) corresponding to a desired channel to an adder 73 at one input end from an fOSC (EXPE) memory 72. On the other hand, an AFT voltage (divalent output) VAFT from an AFT detector 9 is input into an AFT controller 74 and is used to switch a switching circuit 75. The AFT controller 74 will switch the switching circuit 75 to the data memory nF STEP side in order to increase the frequency at a fixed step F STEP when the VAFT is "1" but will switch the switching circuit 75 to the data memory -nF STEP side in order to decrease the frequency at a fixed step F STEP when the VAFT is "0". The output from the switching circuit 75 is fed to an adder 76 at one input end. The value of $\Delta$ fOSC* set in a $\Delta$ fOSC* memory 77 then is fed to the adder 76 at the other input end. The AFT controller 74 detects from the variation of the VAFT that the value of the $\Delta$ fOSC* memory 77 has become the frequency of the downward directed arrow in Figs. 13 and 17 (that is, detects that the AFT has been led in) and transmits it to a spurious lead-in detector 78 and to the $\Delta$ fOSC* memory 77. When the AFT is led in, the $\Delta$ fOSC* memory 77 will be loaded with the data of an adder 76. Its frequency data $\Delta$ fOSC* are fed to the above mentioned adder 73 at the other input end and are added to the frequency data fOSC (EXPE) in the adder 73 and the added output (digital data) is converted to an analogue voltage value V2 (fOSC*) by a converter 79 and is output.

On the other hand, FI + ε and FI - ε are means of generating fixed frequency data FI + ε and FI - ε for judging whether the frequency led in by AFT is a spurious frequency FI or not so that, when the AFT leads in the frequency, FI + ε or FI - ε will be switched and the fixed frequency FI + ε or FI - ε will be fed to a subtracter 81 at one input end (+). Here, FI = 1.5 MHz and ε = 0.1875 MHz. The value of $\Delta$ fOSC* set at the $\Delta$ fOSC* memory 77 then is fed to the subtracter 81 at the other input end (-). The above mentioned spurious lead-in detector 78 controls the switching circuit 80 to be switched to the a side or b side when the AFT is led in and judges the output of the subtracter 81 to be positive or negative so that, in case the switching circuit 80 is positive when on the a side and is negative when on the b side, the AFT will be considered to be led into the spurious I and this will be transmitted to the controlling circuit 71. When the AFT is led into the spurious I, the controlling circuit 71 will reset the $\Delta$ fOSC* memory 77 to make the fOSC* output fOSC (EXPE). At this time, the controlling circuit 71 will judge this channel to be of no signal so that, at the time of an up/down channel selection, that channel will not be selected but the next channel will be selected or, at the time of a direct channel selection, the picture will be made, for example, blue (called a blue back) and the sound will be muted.

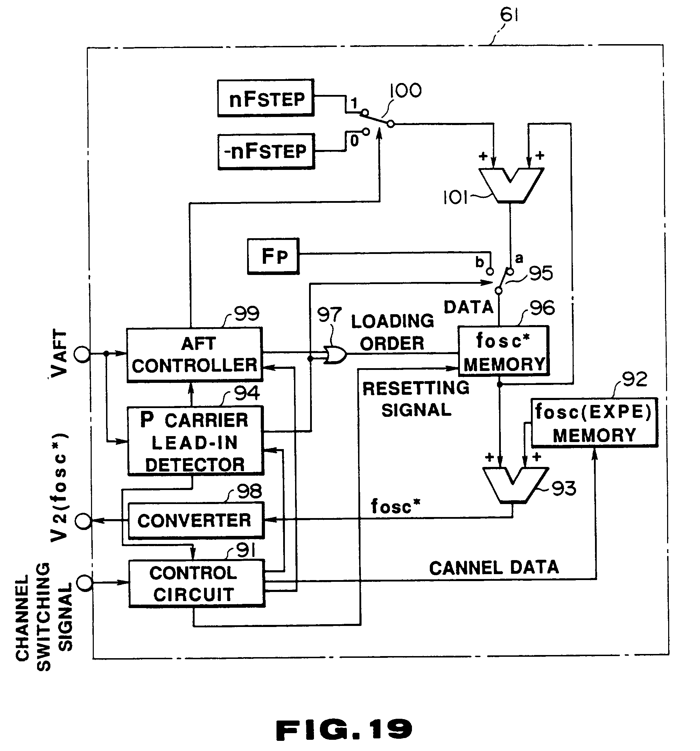

In Fig. 18, by detecting that the AFT is led into the spurious I, the desired channel is judged to have no signal but, in Fig. 19, by detecting that it is not led into the vicinity of the video carrier P, the desired channel is judged to have no signal.

In Fig. 19, on the basis of an input channel switching signal, the controlling circuit 91 delivers frequency data fOSC (EXPE) corresponding to the desired channel to an adder 93 at one input end from an fOSC (EXPE) memory 92. On the other hand, an AFT voltage (divalent output) VAFT from an AFT detector 9 is input into a P carrier lead-in detector 94 and is used to switch a switching circuit 95. When the AFT is led in, the P carrier lead-in detector 94 will switch the switching circuit 95 so as to feed data FP from a data memory FP to a $\Delta$ fOSC* memory 96. The data FP are about +0.2 MHz (See Figs. 13 and 17). When the AFT is led in, the $\Delta$ fOSC* memory 96 will receive a loading order through an OR-gate 97 from the P carrier lead-in detector 94 and will be loaded with the data FP. The output of the $\Delta$ fOSC* memory 96 is fed to the above mentioned adder 93 at the other input end and the value combined with the frequency data fOSC (EXPE) by the adder 93 is made the value of fOSC*. That is to say,

$$fOSC* = fOSC \ (EXPE) + \Delta \ fOSC*$$
$$\Delta \ fOSC* = FP \simeq 0.2 \ MHz.$$

In the P carrier lead-in detector 94, after the above mentioned fOSC* is delivered through a converter 98, after a predetermined time, the AFT voltage VAFT is measured and, when it is 0V, that is, "0" in FP as in Fig. 13, a video carrier P will be recognized to be present and the control will be transferred to an AFT controller 99. At this time, the switch circuit 95 is switched to the a side. By the way, the converter 98 is to convert digital data fOSC* to an analogue voltage value V2 (fOSC*).

When VAFT measured by the P carrier lead-in detector 94 is 5V, that is, "1", the video carrier P of the desired channel will be judged to be absent and this will be transmitted to the controlling circuit 91. In the controlling circuit 91, the $\Delta$ fOSC* memory 96 is reset and the fOSC* output is made fOSC (EXPE). Also, at this time, the controlling circuit 71 will operate the same as in the case of Fig. 18 and, at the time of an up/down channel selection, that channel will not be selected but the next channel will be selected or, at the time of a direct channel selection, the picture will be made, for example, blue (called a blue back) and the sound will be muted.

By the way, after the control is transferred to the AFT controller 99, the AFT detector 9 will output an AFT voltage VAFT corresponding to V2 (fOSC*) and the AFT controller 99 will operate an AFT loop to search f02. That is to say, the AFT voltage (divalent output) from the AFT detector 9 will be input into the AFT controller 99 and will be used to switch a switching circuit 100. By the AFT controller 99, the switch circuit 100 is switched to the data memory nF STEP side in order to increase the frequency at a fixed step F STEP when the VAFT is "1" but to the data memory -nF STEP side in order to decrease the frequency at a fixed step F STEP when the VAFT is "0". The output from the switch circuit 100 is fed to an adder 101 at one input end. The value of $\Delta$ fOSC* set then at the $\Delta$ fOSC* memory 96 is fed to the adder 101 at the other input end. The output of the adder 93 is output as V2 (fOSC*) through the converter 98. The AFT detector 9 outputs an AFT voltage VAFT corresponding to V2 (fOSC*).

As described above, according to the formation in Fig. 11 and the formation of the operation circuit in Fig. 18 or 19, in case there is no broadcast signal in a desired channel but there are broadcast signals in the upper and lower adjacent channels, the mis-operation of selecting channels by the obstruction by mixed signals (generated particularly in a strong electric field region) can be prevented. Therefore, the present invention is useful for automatically selecting channels by detecting present signals and for making a black picture when there is no signal.

Reference signs in the claims are intended for better understanding and shall not limit the scope.

**Claims**

1. A channel selecting apparatus comprising

   - a tuner (2) controlled by a tuning voltage for mixing an input high frequency signal with a local oscillation signal and for converting the high frequency signal into an intermediate frequency signal;
   - a controlling means (5,6) for controlling the tuning voltage of said tuner by using data corresponding to local oscillation frequencies of channels selected by a channel-up or channel-down channel selecting operation;

     **charaterized by**

   - a means (65) for memorizing commonly for a plurality of channels which are not allowed to exist simultaneously the information as to whether it is inhibited or permitted to select respective channels at the time of a channel-up or channel-down selection.

2. A channel selecting apparatus according to claim 1 further comprising

   - a size judging means (7, 8) for judging the sizes of a frequency of said input high frequency signal at a channel selecting time and the tuned frequency corresponding to said local oscillating frequency at a search starting time; and
   - means (61) for controlling by a negative feed back said tuned frequency to decrease said tuned frequency when said size judging means (7, 8) indicates that said tuner frequency at the search starting time is larger than the frequency of said input high frequency signal and to increase said tune frequency when said size judging means (7, 8) indicates that said tuned frequency is smaller than the frequency of said input high frequency signal, whereby the channel selection is controlled to proceed towards the frequency of said input high frequency signal.

3. A channel selecting apparatus according to claim 1 further comprising

   - an AFT detecting means (9) for outputting as an AFT voltage the difference of the frequency of said intermediate frequency signal from a prescribed frequency when the local oscillation frequency of said tuner (2) is swept in a predetermined direction; and
   - a means (61) for judging whether the AFT has been led into a sound carrier or colour sub-carrier and for detecting the lead into a video carrier by utilizing the frequency differences between video carrier and said sound carrier of the lower adjacent channel and between said video carrier and said colour sub-carrier.

4. A channel selecting apparatus according to claim 1 further comprising

   - an AFT detecting means (9) for outputting as an AFT voltage the difference of the frequency of said intermediate frequency signal from a prescribed frequency when the local oscillation frequency of said tuner (2) is swept in a predetermined direction; and
   - means (61) for judging whether the AFT has been led in a specific frequency or not and for detecting that there is no signal in the desired channel by utilizing the difference between said data corresponding to said local oscillation frequencies and said local oscillation frequency data corresponding to the video carrier of a desired channel.

5. A channel selecting apparatus according to anyone of claims 1 to 4 further comprising

   - A PLL part (5) for preparing a tuning voltage by using the data corresponding to the local oscillation frequencies from said memorizing means (6) and for controlling the local oscillation frequency of said tuner (2) to coincide with the data corresponding to the local oscillation frequencies.

6. A channel selecting apparatus according to claim 5 further comprising

- a first position memory (62) for memorizing a channel corresponding to a first position;

- a last position memory (63) for memorizing a channel corresponding to a last position;

- a channel number memory (64) for memorizing channel number data corresponding to a position number;

- a skip flag memory (65) for memorizing the information as to whether a channel is to be skipped or not at the time of a time channel-up or a channel-down channel selection;

- a position number memory (67) for memorizing a position number;

- a stop position memory (66) for memorizing a position up by one from the present position at the up/down channel selecting starting time point;

- a data memory ($f_{OSB*}$ memory) for memorizing data correspond to local oscillation frequencies corresponding to channel numbers; and

- an operation circuit (61) judging a channel to be selected without being skipped when a channel-up or channel-down key input is received, with reference to said skip flag memory (65), whereby the judged selected channel is memorized in said position number memory (67), data correspond to this position being read out of said channel number memory (64) and data corresponding to local oscillation frquencies corresponding to said channel number being prepared with reference to said data memory ($f_{OSC*}$ memory) corresponding to local oscillation frequencies and being output to said PLL part (5).

**Patentansprüche**

1. Kanalauswahlvorrichtung mit:

- einem Tuner (2), gesteuert durch eine Abstimmspannung zum Mischen eines Eingabehochfrequenzsignals mit einem lokalen Oszillationssignal und zum Umwandeln des Hochfrequenzsignals in ein intermediäres Frequenzsignal;

- einer Steuereinrichtung (5, 6) zum Steuern der Abstimmspannung des Tuners unter Benutzung von Daten entsprechend lokaler Oszillationsfrequenzen von Kanälen, ausgewählt durch einen Kanal-Auf- oder Kanal-Ab-Kanalauswahlbetrieb;

**gekennzeichnet** durch

- eine Einrichtung (65) zum Speichern in gemeinsamer Weise für eine Vielzahl von Kanälen, welche nicht simultan existieren dürfen, der Information, ob es verhindert oder zugelassen ist, jeweilige Kanäle auszuwählen zur Zeit einer Kanal-Auf- oder Kanal-Ab-Kanalauswahl.

2. Kanalauswahlvorrichtung nach Anspruch 1, **gekennzeichnet** durch

- eine Größenbeurteilungseinrichtung (7, 8) zum Beurteilen der Größen einer Frequenz des Eingabehochfrequenzsignals zu einer Kanalauswahlzeit und der abgestimmten Frequenz entsprechend der lokalen Oszillationsfrequenz bei einer Suchstartzeit; und

- einer Einrichtung (61) zum Steuern durch negative Rückkopplung der abgestimmten Frequenz, daß die abgestimmte Frequenz abnimmt, wenn die Größenbeurteilungseinrichtung (7, 8) anzeigt, daß die Tunerfrequenz bei der Suchstartzeit größer ist als die Frequenz des Eingabehochfrequenzsignals, und zum Erhöhen der abgestimmten Frequenz, wenn die Größenbeurteilungseinrichtung (7, 8) anzeigt, daß die abgestimmte Frequenz kleiner ist als die Frequenz des Eingabehochfrequenzsignals, wodurch die Kanalauswahl gesteuert wird voranzuschreiten zur Frequenz des Eingabehochfrequenzsignals.

3. Kanalauswahlvorrichtung nach Anspruch 1, **gekennzeichnet** durch:

- eine AFT-Erfassungseinrichtung (9) zum Ausgeben als AFT-Spannung der Differenz der Frequenz des intermediären Frequenzsignals von einer vorgeschriebenen Frequenz, wenn die lokale Oszillationsfrequenz des Tuners (2) in eine vorbestimmte Richtung gefahren wird; und

- eine Einrichtung (61) zum Beurteilen, ob der AFT geführt worden ist in einen Klangträger oder einen Farbunterträger und zum Erfassen des Führens in einen Videoträger durch Benutzung der Frequenzdifferenzen zwischen dem Videoträger und dem Klangträger des niedrigeren benachbarten Kanals und zwischen dem Videoträger und dem Farbunterträger.

4. Kanalauswahlvorrichtung nach Anspruch 1, **gekennzeichnet** durch:

- eine AFT-Erfassungseinrichtung (9) zum Ausgeben als AFT-Spannung der Differenz der Frequenz des intermediären Frequenzsignals von einer vorbeschriebenen Frequenz, wenn die lokale Oszillationsfrequenz des Tuners (2) in eine vorbestimmte Richtung gefahren wird; und

- eine Einrichtung (61) zum Beurteilen, ob der AFT geführt worden ist in eine spezifische Frequenz oder nicht, und zum Erfassen, daß es kein Signal in dem erwünschten Kanal gibt, durch Benutzen der Differenz zwischen den Daten entsprechend den lokalen Oszillationsfrequenzen und den lokalen Oszillationsfrequenzdaten entsprechend dem Videoträger eines erwünschten Kanals.

5. Kanalauswahlvorrichtung nach einem der Ansprüche 1 bis 4,
   **gekennzeichnet** durch:

   - einen PLL-Teil (5) zum Schaffen einer Abstimmspannung durch Benutzen der Daten entsprechend den lokalen Oszillationsfrequenzen von der Speichereinrichtung (6) und zum Steuern der lokalen Oszillationsfrequenz des Tuners (2) auf eine Übereinstimmung mit den Daten entsprechend der lokalen Oszillationsfrequenz.

6. Kanalauswahlvorrichtung nach Anspruch 5,
   **gekennzeichnet** durch:

   - einen Erstpositionsspeicher (62) zum Speichern eines Kanals entsprechend einer ersten Position;

   - einen Letztpositionsspeicher (63) zum Speichern eines Kanals entsprechend einer letzten Position;

   - einen Kanalnummernspeicher (64) zum Speichern von Kanalnummerdaten entsprechend einer Positionsnummer;

   - einen Überspring-Flagspeicher (65) zum Speichern der Information, ob ein Kanal zu überspringen ist oder nicht zur Zeit einer Kanal-Auf- oder Kanal-Ab-Kanalauswahl;

   - einen Positionsnummernspeicher (67) zum Speichern einer Positionsnummer;

   - einen Stoppositionsspeicher (66) zum Speichern einer Position um Eins höher von der vorliegenden Position zum Auf-/Ab-Kanalauswahl-Startzeitpunkt;

   - einen Datenspeicher ((fOSB$^*$-Speicher) zum Speichern von Daten entsprechend lokalen Oszillationsfrequenzen entsprechend Kanalnummern; und

- einer Betriebsschaltung (61) zum Beurteilen eines auszuwählenden Kanals, ohne übersprungen zu werden, wenn eine Kanal-Auf- oder Kanal-Ab-Tasteneingabe empfangen wird, und zwar mit Bezug auf den Überspring-Flagspeicher (65), wodurch der beurteilte ausgewählte Kanal gespeichert wird in dem Positionsnummernspeicher (67), Daten entsprechend dieser Position ausgelesen werden von dem Kanalnummernspeicher (64) und Daten entsprechend Lokaloszillationsfrequenzen entsprechend der Kanalnummer bereitet werden in Bezug auf den Datenspeicher (fOSC$^*$-Speicher) entsprechend lokalen Oszillationsfrequenzen und ausgegeben werden an den PLL-Teil (5).

## Revendications

1. Appareil de sélection de canal, comprenant :

   un syntoniseur (2) commandé par une tension de réglage d'accord de fréquence et servant à mélanger un signal de haute fréquence d'entrée avec un signal d'oscillation locale et à convertir le signal de haute fréquence en un signal de fréquence intermédiaire ; et
   un moyen de commande (5, 6) servant à commander la tension de réglage d'accord de fréquence dudit syntoniseur à l'aide de données correspondant aux fréquences d'oscillation locale de canaux sélectionnés dans une opération de sélection de canal par élévation ou abaissement de numéro de canal ;
   caractérisé par :
   un moyen (65) servant à mémoriser en commun, pour une pluralité de canaux qui ne sont pas laissés exister simultanément, les informations indiquant s'il est interdit ou permis de sélectionner des canaux respectifs au moment d'une sélection par élévation ou abaissement de numéro de canal.

2. Appareil de sélection de canal selon la revendication 1, comprenant en outre :

   un moyen de détermination de taille (7, 8) servant à déterminer la taille de la fréquence dudit signal de haute fréquence d'entrée à un moment de sélection de canal et celle de la fréquence accordée correspondant à ladite fréquence d'oscillation locale à un moment de début de recherche ; et
   un moyen (61) servant à ajuster par réaction négative ladite fréquence accordée afin de diminuer ladite fréquence acccordée lorsque ledit moyen de détermination de taille (7, 8) indique que ladite fréquence accordée est, au moment du début de recherche, plus grande que la fréquence dudit signal de haute fréquence d'entrée et afin d'augmenter ladite fréquence accordée lorsque ledit moyen de détermination de taille (7, 8) indique que ladite fréquence accordée est plus petite que la fréquence dudit signal de haute fréquence d'entrée, de sorte que la sélection de canal est commandée de façon à progresser en direction de la fréquence dudit signal de haute fréquence d'entrée.

3. Appareil de sélection de canal selon la revendication 1, comprenant en outre :

un moyen (9) de détection d'accord fin automatique, ou AFT, (9) servant à délivrer, au titre de tension d'accord fin automatique, ou tension AFT, la différence de la fréquence dudit signal de fréquence intermédiaire vis-à-vis d'une fréquence prescrite lorsque la fréquence d'oscillation locale dudit syntoniseur (2) effectue un balayage dans un sens prédéterminé ; et
un moyen (61) servant à déterminer si l'opération d'accord fin automatique, ou opération AFT, a abouti sur une porteuse son ou une sous-porteuse de chrominance et à détecter l'aboutissement sur une porteuse vidéo par utilisation des différences de fréquence entre ladite porteuse vidéo et ladite porteuse son du canal adjacent inférieur et entre ladite porteuse vidéo et ladite sous-porteuse de chrominance.

4. Appareil de sélection de canal selon la revendication 1, comprenant en outre :

un moyen (9) de détection d'accord fin automatique, ou détection AFT, servant à délivrer, au titre de tension d'accord fin automatique, ou tension AFT, la différence de la fréquence dudit signal de fréquence intermédiaire vis-à-vis d'une fréquence prescrite lorsque la fréquence d'oscillation locale du syntoniseur (2) effectue un balayage dans un sens prédéterminé ; et
un moyen (61) servant à déterminer si l'opération d'accord fin automatique, ou opération AFT, a abouti ou non sur une fréquence spécifique et servant à détecter qu'il n'y a pas de signal dans le canal voulu par utilisation de la différence entre lesdites données correspondant auxdites fréquences d'oscillation locale et lesdites données de fréquence d'oscillation locale correspondant à la porteuse vidéo d'un canal voulu.

5. Appareil de sélection de canal selon l'une quelconque des revendications 1 à 4, comprenant en outre :

une partie boucle à phase asservie, ou partie PLL, (5) servant à préparer une tension de réglage d'accord par utilisation des données correspondant aux fréquences d'oscillation locale venant dudit moyen de mémorisation (6) et à ajuster la fréquence d'oscillation locale dudit syntoniseur (2) afin d'obtenir la coïncidence avec les données correspondant aux fréquences d'oscillation locale.

6. Appareil de sélection de canal selon la revendication 5, comprenant en outre :

une mémoire de première position (62) servant à mémoriser un canal correspondant à une première position ;
une mémoire de demière position (63) servant à mémoriser un canal correspondant à une dernière position ;
une mémoire de numéro de canal (64) servant à mémoriser des données de numéro de canal correspondant à un numéro de position ;
une mémoire de drapeaux de saut (65) servant à mémoriser les informations indiquant si un canal doit ou non être sauté au moment d'une sélection de canal par élévation ou abaissement de canal ;
une mémoire de numéro de position (67) servant à mémoriser un numéro de position ;
une mémoire de position d'arrêt (66) servant à mémoriser une position élevée de 1 par rapport à la position courante au moment du début de la sélection de canal par élévation ou abaissement ;
une mémoire de données (mémoire de fOSC$^*$) servant à mémoriser des données correspondant à des fréquences d'oscillation locale relatives à des numéros de canal ; et
un circuit d'activation (61) qui détermine un canal devant être sélectionné sans qu'il soit sauté lorsqu'un signal d'entrée par touches d'élévation de canal ou d'abaissement de canal est reçu, en se reportant à ladite mémoire de drapeaux de saut (65), de sorte que le canal sélectionné ayant fait l'objet de la détermination est mémorisé dans ladite mémoire de numéro de position (67), les données correspondant à cette position étant lues dans ladite mémoire de numéro de canal (64), et les données qui correspondent à des fréquences d'oscillation locale correspondant audit numéro de canal étant préparées en liaison avec ladite mémoire de données (mémoire de fOSC$^*$) correspondant aux fréquences d'oscillation locale et étant délivrées à ladite partie PLL (5).

TV/CATV
DEMODULATING

2 TUNER
I F
SIGNAL

TV/CATV
SIGNAL
INPUT

21

FREQUENCY
CONVERTER

3

BPF

4

DEMODULATING
CIRCUIT

22

VCO

5 PLL
PART

$f_{osc}$

CATV
DISPLAY

CH
DISPLAY

53

PHASE
DETECTOR

$-$

$f_o$

PROGRAMABLE
DIVIDER

$f_{osc}^*$

MPU

CH UP
INPUT

CH DOWN
INPUT

CATV/TV
SWITCHING
INPUT

$+$ $f_{ref}$

REFERENCE
OSCILLATOR

52

51

6

**FIG.1**

6 MPU

62

FIRST
POSITION
MEMORY

63

LAST
POSITION
MEMORY

64

CHANNEL
NUMBER
MEMORY

$f_{osc}^*$
MEMORY

CH
NUMBER
DISPLAY

61

$f_{osc}^*$
OUTPUT

OPERATION
CIRCUIT

POSITION
NUMBER
MEMORY

67

CH UP
INPUT

CH DOWN
INPUT

SKIP FLAG
MEMORY

65

STOP
POSITION
MEMORY

66

**FIG.2**

| | RECEIVING CHANNEL | SKIP FLAG | MEMORY CAPACITY |
|---|---|---|---|
| POSITION NO.1 | CATV 1CH | □ | TOTAL 1 BIT |
| POSITION NO.2 | CATV 2CH, VHF 2CH | □ | TOTAL 1 BIT |
| ⋮ | ⋮ | ┊ | ┊ |
| POSITION NO.13 | CATV 13CH, VHF 13CH | □ | TOTAL 1 BIT |
| POSITION NO.14 | CATV 14CH | □ | TOTAL 1 BIT |
| ⋮ | ⋮ | ┊ | ┊ |
| POSITION NO.64 | CATV 64CH | □ | TOTAL 1 BIT |
| POSITION NO.65 | CATV 65CH, UHF 14CH | □ | TOTAL 1 BIT |
| ⋮ | ⋮ | ┊ | ┊ |
| POSITION NO.94 | CATV 94CH, UHF 43CH | □ | TOTAL 1 BIT |
| POSITION NO.95 | CATV 95CH | □ | TOTAL 1 BIT |
| ⋮ | ⋮ | ┊ | ┊ |
| POSITION NO.99 | CATV 99CH | □ | TOTAL 1 BIT |
| POSITION NO.100 | CATV 100CH, UHF 44CH | □ | TOTAL 1 BIT |
| ⋮ | ⋮ | ┊ | ┊ |
| POSITION NO.125 | CATV125CH, UHF 69CH | □ | TOTAL 1 BIT |

GROSS TOTAL
125 BITS

# FIG.3

**FIG. 4**

**CATV/TV**

**POWER**

| 1 | 2 | 3 | 4 |
| 5 | 6 | 7 | 8 |

**CHANNEL**

| 9 | 0 | ▲ | ▼ |

**UP   DOWN**

MEMORY ADD ERASE
CHANNEL

**FIG. 4**

2 TUNER

21

IF
SIGNAL

3

4

**FREQUENCY
CONVERTER**

**BPF**

**DEMODULATING
CIRCUIT**

TV/CATV
SIGNAL
INPUT

22

TV/CATV
DEMODULATING
OUTPUT

**VCO**

7

**AMPLIFYING
CIRCUIT**

5 PLL
PART 8

$f_{IF}$

$f_{osc}$

51

**SIZE JUDGING
CIRCUIT**

53

**PHASE
DETECTOR**

**PROGRAMABLE
DIVIDER**

$f_{osc}*$

V PD

CH UP
INPUT

$f_o$

52

**MPU**

CH DOWN
INPUT

$+$ $f_{ref}$

**REFERENCE
OSCILLATOR**

6

CATV/TV
SWITCHING
INPUT

CATV
DISPLAY

CH
DISPLAY

**FIG. 6**

15

CATV UP CHANNEL
SELECTION STARTS

(PRESENT POSITION NUMBER
VALUE)+1 ARE PUT INTO
STOP POSITION MEMORY — S1

POSITION NUMBER IS
INCREASED BY 1 — S2

IF POSITION NUMBER EXCEEDS VALUE
OF LAST POSITION MEMORY,
POSITION NUMBER IS MADE VALUE OF
FIRST POSITION MEMORY — S3

YES — IS POSITION NUMBER
EQUAL TO STOP POSITION ? — S4

NO

WHAT IS VALUE OF SKIP
FLAG CORRESPONDING TO
POSITION NUMBER ? — S5

ON(1)

OFF(0)

VALUE OF CHANNEL NUMBER
CORRESPONDING TO POSITION
NUMBER IS DETERMINED — S6

VALUE OF fosc* CORRESPONDING
TO CHANNEL NUMBER IS DETERMINED
WITH REFERENCE TO fosc* MEMORY — S7

CATV DISPLAY, CANNEL
NUMBER DISPLAY — S8

END

# FIG.5

$V_{PD}$

$f_{01}$

$f_{IF}$

## FIG.7

$f_{TUNE}$

$f_S$

$f_{IN}$

## FIG.8

$f_{TUNE}$

$f_{IN}$

$f_S$

## FIG.9

$f_{IF}$

$f_{01}$

## FIG.10

17

**FIG.11**

**FIG.12**

fo2 : VALUE OF fosc* CORRESPONDING
TO VIDEO CARRIER P
OF DESIRED CHANNEL

$\Delta fosc^* = fosc^* - fo2$

**FIG.13**

**FIG.14**

FIG.15

FS ≃ 1.75MHz
FC ≃ 3.31MHz

FIG.16

FIG.17

20

**FIG.18**

**FIG.19**

| POSITION NO.1 | RECEIVING CHANNEL | SKIP FLAG | MEMORY CAPACITY |
|---|---|---|---|
| POSITION NO.1 | CATV 1CH | ☐ | TOTAL 1 BIT |
| POSITION NO.2 | CATV 2CH | ☐ | TOTAL 1 BIT |
| POSITION NO.125 | CATV 125CH | ☐ | TOTAL 1 BIT |
| POSITION NO.126 | UHF 14CH | ☐ | TOTAL 1 BIT |
| POSITION NO.181 | UHF 69CH | ☐ | TOTAL 1 BIT |

GROSS TOTAL 181 BITS

**FIG.20** (RELATED ART)